(19) Europäisches Patentamt
European Patent Office
Office européen des brevets

(11) **EP 2 912 482 B1**

(12) **FASCICULE DE BREVET EUROPEEN**

(45) Date de publication et mention de la délivrance du brevet:
**11.01.2017 Bulletin 2017/02**

(21) Numéro de dépôt: **13779260.2**

(22) Date de dépôt: **18.09.2013**

(51) Int Cl.:
*G05B 13/04* (2006.01)    *G01R 31/36* (2006.01)

(86) Numéro de dépôt international:
**PCT/FR2013/052146**

(87) Numéro de publication internationale:
**WO 2014/064349 (01.05.2014 Gazette 2014/18)**

(54) **PROCÉDÉ D'UTILISATION D'UN SYSTÈME DE STOCKAGE D'ÉNERGIE ÉLECTRIQUE**

VERFAHREN ZUR VERWENDUNG EINES SYSTEMS ZUR SPEICHERUNG VON ELEKTRISCHER ENERGIE

METHOD FOR USING AN ELECTRICAL ENERGY STORAGE SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.10.2012 FR 1202848**

(43) Date de publication de la demande:
**02.09.2015 Bulletin 2015/36**

(73) Titulaire: **IFP Énergies nouvelles**
**92852 Rueil-Malmaison Cedex (FR)**

(72) Inventeurs:
• PRADA, Eric
F-42370 Renaison (FR)
• DI DOMENICO, Domenico
F-69007 Lyon (FR)
• CREFF, Yann
F-38138 Les Cotes D'arey (FR)

(56) Documents cités:
WO-A1-2011/015307    FR-A1- 2 826 457
FR-A1- 2 961 351    FR-A1- 2 970 820

## Description

La présente invention concerne le domaine des systèmes de stockage d'énergie électrique tels que les batteries.

En particulier, l'invention concerne un procédé d'utilisation d'un système de stockage d'énergie dans lequel on conçoit un profil d'utilisation optimisé du système permettant de limiter le vieillissement du système.

Un profil d'utilisation d'une batterie représente la puissance (P) ou le courant (I) en fonction du temps. Il peut s'agir d'un profil de charge, d'un profil de décharge, ou d'un profil de charges et de décharges. Un tel profil est dit optimisé au sens de l'invention, lorsqu'il permet de limiter le vieillissement de la batterie.

Dans une industrie automobile et énergétique en pleine mutation, les batteries de technologie Li-ion font l'objet de nombreux travaux de R&D afin de pouvoir concevoir des systèmes robustes, fiables et endurants pour véhicules électrifiés.

Représentant un coût important dans les véhicules PHEV (Plug-In Hybrid Electric Vehicle) et EV (Electric Vehicle), les batteries Li-ion sont des systèmes dont on cherche à augmenter la durée de vie.

En effet, afin d'assurer l'essor de ces systèmes au niveau industriel, le coût et le vieillissement des batteries doivent être réduits. Particulièrement, la phase de recharge des véhicules électrifiés conditionne fortement l'essor de ces nouvelles technologies automobiles. Des critères de sécurité, de durabilité et de rapidité de la recharge doivent être respectés lors de cet usage du véhicule.

Pour des raisons pratiques d'usage, le temps de recharge doit être optimisé pour l'utilisateur tout en assurant une durabilité et un fonctionnement sécuritaire du système de stockage de l'énergie électrique.

Il est donc nécessaire de définir pour chaque batterie un profil d'utilisation (profil de charge/décharge) optimisé, c'est-à-dire, un profil permettant de ralentir le vieillissement de la batterie.

Pour ce faire, on ajuste une stratégie de recharge sur la base d'un modèle mathématique du vieillissement, afin de réduire les phénomènes de dégradation au fur et à mesure des recharges.

On connaît des procédés qui utilisent des modèles génériques de comportement du vieillissement de système Li-ion soit à base de cartographies issues d'essais expérimentaux, soit des modèles empiriques statiques rendant compte de l'impact des facteurs de stress sur le vieillissement. De telles techniques sont décrites dans les documents suivants :

- A. Hoke, A. Brisette, D. Maksimovic, A. Pratt, K. Smith, Vehicle Power Propulsion Conference, (2011)
- B. Lunz, H. Walz, D. U. Sauer,Vehicle Power Propulsion Conference, (2011)

Ces modèles sont ensuite couplés à des algorithmes d'optimisation qui ont pour but de trouver le profil d'utilisation optimal en minimisant une fonction coût conçue à partir d'indicateurs du niveau de vieillissement du système, indicateurs généralement calculés à partir d'un modèle mathématique de vieillissement.

Concernant les travaux portant sur les profils de charge/décharge, on peut également citer le procédé décrit dans :

- A. Hoke, A. Brisette, D. Maksimovic, A. Pratt, K. Smith, Vehicle Power Propulsion Conference, (2011)

Cette approche statique de la modélisation du vieillissement est basée sur des modèles semi-empiriques et statiques tandis le second groupe a adopté une approche physique simplifiée isotherme de type Single-Particle. Dans leurs travaux, Hoke et al. optimisent la charge d'un véhicule électrique sur une durée de 24h en partant d'un SOC initial autour de 30%. Leurs résultats d'optimisation tendent à montrer qu'il serait préférable de retarder la charge et d'appliquer des puissances croissantes (sous forme de rampe).

FR2961351 divulgue la détermination de l'état de santé d'une batterie à partir d'un modèle prédictif. FR2970820 divulgue un procédé de gestion de la charge d'une batterie rechargeable comprenant au moins un module incluant au moins une cellule électrochimique qui comprend une phase d'estimation d'un flux de chaleur produit dans l'au moins un module.

Différentes demandes de brevet (US 2006/0071634, US 2005/0156577, EP 2 193 587, US 2009/0208817) traitent de la problématique des chargeurs de batterie Li-ion. Ces chargeurs peuvent avoir différentes fonctionnalités de profils de charge comme l'application de courant pulsé et peuvent héberger différentes stratégies pour optimiser l'énergie utilisable ou la durée de vie du système. Ces stratégies de gestion sont soit prédéfinies, soit adaptatives. On connait également des algorithmes de recharge basés sur des modèles physiques avec prise en compte de certains indicateurs de vieillissement.

Mais ces modèles sont de nature statique, et donc peu prédictifs vis à vis des phénomènes dynamiques.

Ainsi, l'objet de l'invention est un procédé pour définir un profil optimal d'utilisation d'un système de stockage d'énergie électrique permettant de minimiser le vieillissement dudit système, au moyen d'un modèle dynamique de vieillissement du système. Ce caractère dynamique permet de modéliser les pertes de capacité électrique et/ou de puissance du système en fonction du temps, à l'inverse des modèles statiques de l'art antérieur.

Ce procédé permet de prendre en compte les transitoires électriques et thermiques, ainsi que l'état initial du vieillissement, ce qui conduit à des résultats plus précis. De plus, ce procédé permet de tester un spectre de profils de charge plus large et réaliste, par rapport à l'utilisation d'un modèle statique.

**Le procédé selon l'invention**

De façon générale, l'invention concerne un procédé d'utilisation d'un système de stockage d'énergie électrique, ledit système comportant une électrode positive, une électrode négative et un electrolyte, dans lequel :

- on définit un profil optimal d'utilisation dudit système permettant de minimiser le vieillissement dudit système, ledit profil optimal d'utilisation étant défini en réalisant les étapes suivantes :

  i) on choisit un profil initial d'utilisation ;

  ii) on définit un modèle dynamique de vieillissement dudit système modélisant des pertes de capacité électrique et/ou de puissance dudit système, ledit modèle étant un modèle dynamique en ce qu'il modélise les pertes en fonction du temps et en ce qu'il prend en compte un état de vieillissement initial dudit système avant application dudit profil initial d'utilisation ;

  iii) on détermine un indicateur de vieillissement du système après application dudit profil initial d'utilisation audit système, au moyen dudit modèle dynamique de vieillissement ;

  iv) on modifie le profil d'utilisation initial et l'on réitère à l'étape iii) jusqu'à obtenir un indicateur de vieillissement minimal;

- et on applique ledit profil optimal audit système.

Selon l'invention, le modèle dynamique de vieillissement peut prendre en compte un impact du profil d'utilisation sur le système tout au long du profil d'utilisation.

Le modèle dynamique de vieillissement peut décrire des pertes de capacité électrique et/ou de puissance du système en fonction de facteurs opérationnels de courant, de température, d'état de charge (SOC), et de balayage de plage d'état de charge (DOD).

Le modèle dynamique de vieillissement peut reproduire le comportement dynamique électrochimique et thermique du système, en modélisant les mécanismes de dégradation des électrodes menant à une perte de capacité et une perte de puissance.

Selon un mode de réalisation, le modèle dynamique de vieillissement comporte :

- un modèle décrivant une évolution d'une couche de particule formée en surface d'une électrode;

- un modèle décrivant que l'épaisseur de ladite couche croît par consommation d'espèces actives ;

- un modèle décrivant que des molécules de l'électrolyte se réduisent à une interface entre une électrode et ladite couche après avoir traversées ladite couche par diffusion et convection.

Le profil d'utilisation peut être un profil de courant ou un profil de puissance.

Le profil d'utilisation peut être un profil de charge du système ou un profil de décharge du système, ou un profil correspondant à un ensemble de charges et de décharges.

Le système de stockage d'énergie électrique peut être une batterie Li-ion, ou Ni-MH, ou Pb-Acide ou une ultracapacité.

Selon l'invention, l'indicateur de vieillissement peut être une perte de capacité électrique ou une perte de puissance.

On peut modifier le profil d'utilisation jusqu'à obtenir un indicateur de vieillissement minimal au moyen d'un algorithme d'optimisation sous contrainte.

D'autres caractéristiques et avantages du procédé selon l'invention, apparaîtront à la lecture de la description ci-après d'exemples non limitatifs de réalisations, en se référant aux figures annexées et décrites ci-après.

**Présentation succincte des figures**

- La figure 1A montre un profil en courant d'utilisation type d'un véhicule électrique.

- La figure 1B montre l'évolution (en fonction du temps t) de l'état de charge (SOC) de la batterie sur une journée, après application du profil de la figure 1A.

- La figure 2 décrit les étapes d'établissement du profil optimal d'utilisation selon l'invention.

- La figure 3 est une représentation schématique de la couche de particules formée en surface d'une électrode (SEI).

- La figure 4 illustre les pertes de capacité (PC) après 1800 charges CC à différents C-Rates en fonction du type de refroidissement (« cooling »).

- La figure 5 illustre un résultat d'optimisation de profil de charge obtenu au moyen du procédé selon l'invention. Il s'agit d'un profil de courant optimal.

- La figure 6 illustre un résultat d'optimisation de profil de charge obtenu au moyen du procédé selon l'invention. Il s'agit d'un profil de courant optimal

**Description détaillée de l'invention**

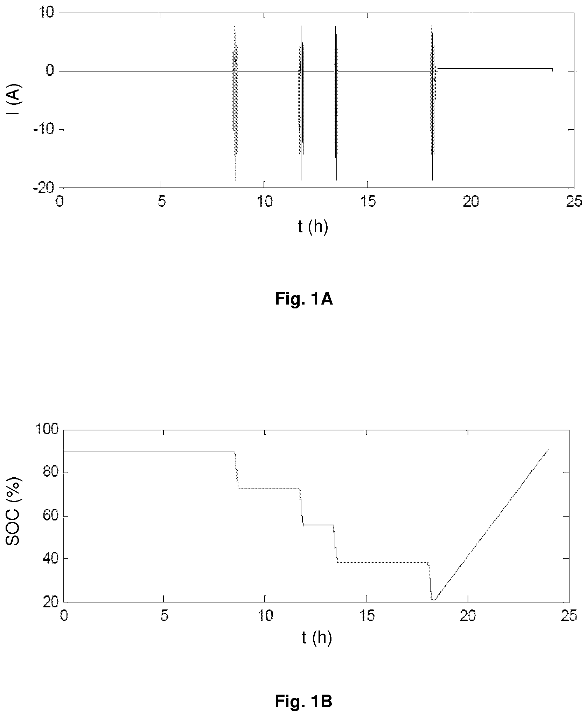

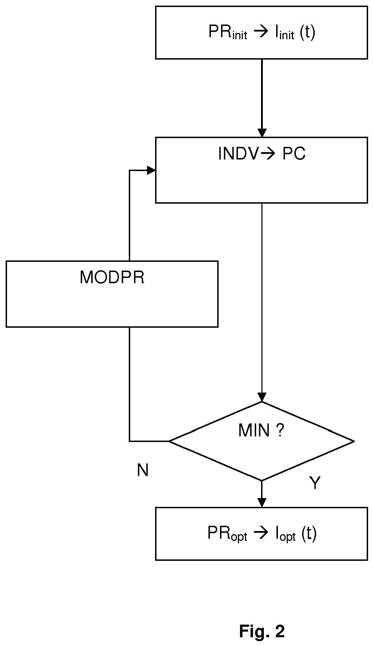

L'invention concerne un procédé d'utilisation d'un système de stockage d'énergie électrique, telle qu'une batterie, dans lequel on établit un profil d'utilisation optimisé du système permettant de limiter le vieillissement de ce système.
Un profil d'utilisation d'une batterie représente la puissance (P) ou le courant (I) en fonction du temps. Il peut s'agir d'un profil de charge, d'un profil de décharge, ou d'un profil de charges et de décharges. Un tel profil est dit optimisé au sens de l'invention, lorsqu'il permet de limiter le vieillissement de la batterie. La figure 1A montre un profil en courant d'utilisation type d'un véhicule électrique. I représente le courant en ampère, et t représente le temps en heure. Quatre phases de roulage (correspondant aux trajets effectués par un conducteur) sont entrecoupées de phases de repos (parking) qui pourraient être mises à profit pour des applications V2G (Vehicle to Grid). La dernière phase, lors de laquelle l'état de charge (SOC) remonte (voir figure 1 B), correspond à la recharge du véhicule.
L'invention est décrite selon un exemple particulier de réalisation, correspondant à une optimisation d'un profil de charge en courant (I). Il s'agit donc déterminer un profil représentant le courant (I) en fonction du temps qui minimise le vieillissement de la batterie une fois celle-ci chargée.
De la même façon l'invention s'applique à un profil de décharge. Dans ce cas, on détermine un profil représentant le courant (I) ou la puissance (P) en fonction du temps qui minimise le vieillissement de la batterie une fois celle-ci déchargée.
De la même façon l'invention s'applique à un profil de charges et décharges. Dans ce cas, on détermine un profil représentant le courant (I) ou la puissance (P) en fonction du temps qui minimise le vieillissement de la batterie une fois que celle-ci aie subi d'un ou plusieurs cycle de charges et décharges.
L'établissement du profil optimal d'utilisation selon l'invention comporte les étapes suivantes (figure 2) :

1. On choisit un profil de charge initial ($PR_{init}$)

2. On détermine un indicateur de vieillissement de la batterie en fonction du profil de charge (INDV)

3. On modifie le profil de charge jusqu'à obtenir un indicateur de vieillissement minimal (MODPR)

1. Choix d'un profil d'utilisation initial ($PR_{init}$)

On définit un profil d'utilisation en fonction du temps à appliquer au système.
Selon l'exemple choisi, on définit un profil I(t) de charge en courant représentant le courant (I) en fonction du temps (t) à appliquer au système pour le recharger. Ce profile initial est noté $I_{init}(t)$.
De façon avantageuse, on définit ce profil comme étant un protocole de charge à courant constant, permettant de charger la batterie en n heures
Par la suite, on calcule le vieillissement du système induit par l'application de ce profil au système. Puis, on modifie le profil, jusqu'à ce que l'on obtienne un vieillissement minimal.

## 2. Détermination d'un indicateur de vieillissement de la batterie en fonction du profil (INDV)

Selon l'invention, on détermine un indicateur de vieillissement de la batterie en fonction du profil I(t), de façon dynamique.

Un modèle de vieillissement est un modèle capable de prédire les pertes de capacité électrique et/ou de puissance d'un élément de batterie, en fonction de facteurs opérationnels de courant, de température, d'état de charge (SOC), et de balayage de plage d'état de charge (DOD) par exemple.

Selon l'invention, le modèle reproduit le comportement dynamique électrochimique, et éventuellement thermique, de la batterie, en modélisant les mécanismes de dégradation des électrodes menant à une perte de capacité et une perte de puissance. Ce modèle représente les phénomènes physico-chimiques et thermiques aux échelles micro et macroscopiques.

Le modèle selon l'invention est dit dynamique car il prend en compte l'historique des évolutions de la batterie, c'est-à-dire qu'il prend en compte tout ce qui intervient sur la batterie avant l'application du profil de charge I(t) et tout ce qui intervient sur la batterie entre le début et la fin de l'application du profil de charge I(t).

Pour ce faire on utilise un modèle de vieillissement, qui prend en compte un état de vieillissement initial de la batterie et la notion du temps au cours du profil, à l'inverse des modèles statiques de l'art antérieur.

Ainsi l'état initial du modèle contient l'historique d'utilisation de la cellule (c'est-à-dire tout ce que s'est passé avant et pendant l'application du profil de charge : l'état de vieillissement final dépend ainsi de l'état initial de la batterie et de tout ce qui est appliqué à la batterie au cours de l'application du profil.

Ainsi, on définit un modèle dynamique de vieillissement de la batterie qui modélise les pertes de capacité électrique et/ou de puissance de la batterie en fonction du temps.

Le modèle de vieillissement comporte notamment :

- un modèle décrivant l'évolution d'une couche de particule formée en surface d'une électrode;

- un modèle décrivant que l'épaisseur de ladite couche croît par consommation d'espèces actives ;

- un modèle décrivant que les molécules de solvant se réduisent à l'interface entre une électrode et ladite couche après avoir traversé ladite couche par diffusion-convection.

Selon un mode de réalisation, ce modèle est construit en considérant le système Li-ion LiFePO$_4$-graphit L'invention est également applicable à des systèmes du type Ni-MH, ultracapacités et Pb-Acide. Ces systèmes sont caractérisés par la présence de :

- 1 électrode positive qui stocke les espèces actives (Li+, Na+, H+,..)

- 1 électrode négative qui stocke les espèces actives (Li+, Na+, H+,..)

- 1 séparateur pour l'isolation électrique entre les 2 électrodes)

- 1 électrolyte pour assurer les échanges ioniques, constitué d'un solvant et de sel)

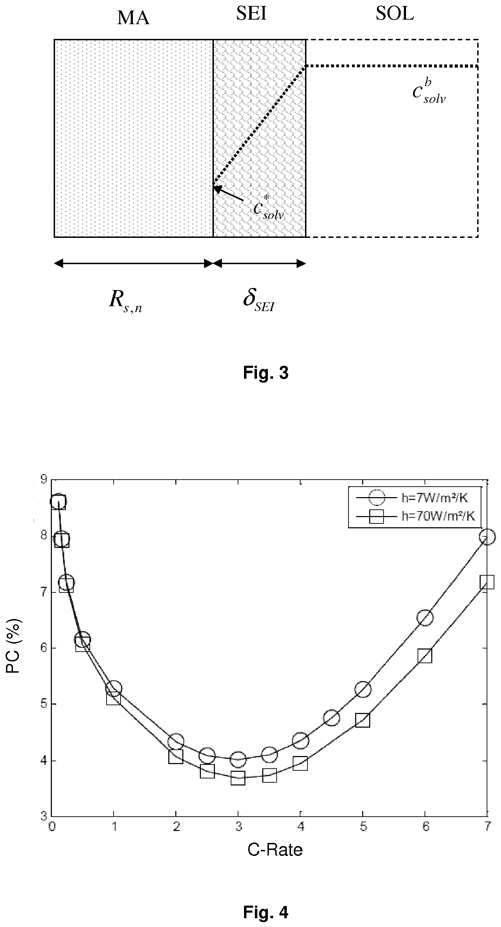

Les batteries Li-ion sont des systèmes composés d'une électrode positive poreuse et d'une électrode négative poreuse séparées par un milieu poreux isolant électroniquement, mais qui assure le passage des ions Li+ d'une électrode à l'autre lors des phases de charge ou de décharge. La porosité des trois compartiments est remplie par une phase électrolytique généralement liquide. La figure 3 est une représentation schématique de la couche de particules (SEI) formée en surface d'une électrode (matière active de l'électrode négative), dans laquelle :

- MA est la matière active ;

- SOL est la solution (phase Electrolytique)

- SEI est la couche polymère poreuse et amorphe (~100 nm)

Les réactions de stockage électrochimique de l'énergie électrique en charge de l'accumulateur peuvent être représentées par les équations 1 et 2 suivantes :

$$LiFePO_4 \xrightarrow{\text{Charge}} yLi^+ + ye^- + Li_{1-y}FePO_4 \qquad \text{pour l'électrode positive} \qquad (1)$$

$$xLi^+ + xe^- + Li_{1-x}C_6 \xrightarrow{\text{Charge}} LiC_6 \qquad \text{pour l'électrode négative} \qquad (2)$$

Pendant les phases de décharge de l'accumulateur, les réactions inverses se produisent.

Un modèle de vieillissement permet de représenter à la fois les pertes de capacité et de puissance. Selon un exemple, l'hypothèse de ce modèle est que la source de vieillissement provient de la consommation de Lithium cyclable (Li+) par réduction du solvant (S) à l'électrode négative (3). Notons que pour d'autres systèmes, on peut avoir des vieillissements faisant intervenir une oxydation du solvant à l'électrode positive.

La couche de particule formée en surface de l'électrode négative est nommée SEI (Solid Electrolyte Interphase).

La SEI va croître continuellement au long de la vie de la batterie et va à la fois consommer des espères actives (perte de capacité) et faire augmenter la résistance électrique de la batterie (perte de puissance). Une représentation schématique de la SEI en surface des particules de l'électrode négative est illustrée sur la figure 3.

Comme illustré sur la figure 3, la SEI est un milieu complexe qui peut être modélisé par une couche poreuse polymérique épaisse (~100 nm). Les molécules de solvant vont se réduire à l'interface électrode négative/SEI (équations 3-4-5 du tableau 1) après avoir traversé la couche SEI par diffusion-convection (équation 6). Au fur et à mesure que l'épaisseur de la SEI va croître (équation 7), la porosité de l'électrode négative va diminuer (équation 8). Selon l'hypothèse du mécanisme précité, il est possible de définir une épaisseur critique de SEI correspondant à un bouchage complet de la porosité de l'électrode (équation 9). La diminution de la porosité de l'électrode négative va provoquer une augmentation d'impédance du système par une modification des propriétés effectives de transport des ions Li$^+$ dans la phase électrolytique (équation 10). La croissance de la couche SEI va aussi impacter la résistance $R_{SC}$ définie par l'équation (équation 11).

Un exemple de modèle est décrit ci-après (tableau 1 et tableau 2 pour les processus thermiques). La thermique du système est un facteur prépondérant dans l'activation du comportement électrique du système de stockage. Ce modèle est un modèle physique électrochimique et thermique d'un système Li-ion de technologie LiFePO$_4$-graphite.

Tableau 1: Équations du modèle de vieillissement dynamique

| Mécanisme de croissance de couche SEI par diffusion du solvant et modification de la porosité de l'électrode négative | Eq | Conditions Limites |
|---|---|---|
| Réaction de réduction du solvant à l'électrode négative $\qquad S + 2e^- + 2Li^+ \rightarrow P$ | (3) | |
| Cinétique de Tafel pour la réaction de réduction du solvant $\qquad i_s = -i_s^0 \exp\left(\dfrac{\beta F}{RT}\dfrac{\delta_{SEI}}{\kappa_{SEI}}\dfrac{I}{S_n}\right)\exp\left(-\dfrac{\beta F}{RT}(\phi_{s,n}-U_s)\right)\exp\left(\dfrac{-E_{a,k}}{R}\left(\dfrac{1}{T_{int}}-\dfrac{1}{T_{ref}}\right)\right)$ | (4) | |
| Equation de conservation du courant $\qquad i_t = i_{nt} + i_s$ | (5) | |
| Bilan de masse sur le solvant $\qquad \dfrac{\partial}{\partial t}C_{solvent} = D_{solvent}\dfrac{\partial^2}{\partial r^2}C_{solvent} - \dfrac{d}{dt}\delta_{SEI}\dfrac{\partial}{\partial r}C_{solvent}$ | (6) | $-D_{solvent}\dfrac{\partial}{\partial r}C_{solvent}\Big|_{r=R_{s,n}}$ $+\dfrac{d}{dt}\delta_{SEI}C_{solvent}\Big|_{r=R_{s,n}} = \dfrac{i_s}{F}$ |
| Vitesse de croissance de la SEI $\qquad \dfrac{d}{dt}\delta_{SEI} = -\dfrac{i_s M_{SEI}}{2F\rho_{SEI}}$ | (7) | $C_{solvent}\Big|_{r=R_{s,n}+\delta_{SEI}} = \varepsilon_{SEI}C_{solvent}^{bulk}$ |
| Modification de la porosité $\qquad \dfrac{d}{dt}\varepsilon_{e,n} = -\dfrac{3\varepsilon_{s,n}}{R_{s,n}}\dfrac{d}{dt}\delta_{SEI} = +\dfrac{i_s M_{SEI}}{2F\rho_{SEI}}\dfrac{3\varepsilon_{s,n}}{R_{s,n}}$ | (8) | |
| Epaisseur critique de la SEI $\qquad \delta_{SEI}^c = \left(\dfrac{1-\varepsilon_{f,n}}{\varepsilon_{s,n}}-1\right)\dfrac{R_{s,n}}{3}$ | (9) | |
| Evolution de la résistance ohmique lors du vieillissement $\qquad R_{ohm}(t) = \dfrac{1}{2A}\left(\dfrac{\delta_n}{\kappa(c_e)\left\{1-\varepsilon_{s,n}\left(1+\dfrac{3\delta_{SEI}(t)}{R_{s,n}}\right)\right\}^{Brugg,n}} + 2\dfrac{\delta_{sep}}{\kappa_{sep}^{eff}}+\dfrac{\delta_p}{\kappa_p^{eff}}\right)$ | (10) | |
| Evolution de la résistance de demi-cercle défini par impédancemétrie $\qquad R_{SC} = R_{ct}^p + R_{ct}^n + R_{SEI}^n = \dfrac{RT}{Fi_0^p S_p}+\dfrac{RT}{Fi_0^n S_n}+\dfrac{\delta_{SEI}}{\kappa_{SEI}S_n}$ | (11) | |

EP 2 912 482 B1

Tableau 2: Équations du modèle thermique du modèle de vieillissement dynamique Avec :

| Transfert de chaleur et bilan d'énergie | | Eq. |
|---|---|---|
| Bilan d'énergie | $$\frac{d}{dt}T = \frac{1}{M\,C_p}\left(\varphi_{gen} - \varphi_{tra}\right)$$ | (12) |
| Flux thermique généré pendant l'utilisation de la batterie | $$\varphi_{gen} = -\left(\left(V - (U_p - U_n)\right)I + T\frac{d(U_p - U_n)}{dT}I\right)$$ | (13) |
| Flux thermique transféré à l'environnement | $$\varphi_{tra} = h_{conv}A_{cell}(T - T_{amb})$$ | (14) |
| Couplage entre le modèle de vieillissement électrochimique et le modèle thermique | | |
| Loi d'Arrhenius appliquée aux paramètres du transport de matière et aux paramètres cinétiques $\Psi$ | $$\Psi = \Psi_{ref}\exp\left(\frac{E_a(\Psi)}{R}\left(\frac{1}{T_{ref}} - \frac{1}{T}\right)\right)$$ | (15) |

$A$      Aire géométrique des électrodes ($m^2$)

$A_{cell}$      Surface externe de la batterie ($m^2$)

$c_e$      concentration de lithium dans la phase électrolytique (mol $m^{-3}$)

$C_{solvent}^{*}$      concentration de lithium à l'interface électrode/SEI (mol $m^{-3}$)

$C_{solvent}^{b}$      concentration de lithium à l'interface SEI/électrolyte (mol $m^{-3}$)

$E_a$      Energie d'activation (J $mol^{-1}$)

$F$      Constante de Faraday (C $mol^{-1}$)

h      Coefficient d'échange thermique (W.$k^{-1}$ .$m^{-2}$)

$i_0$      Densité de courant d'échange électronique (A $m^{-2}$)

$I$      Intensité du courant traversant la cellule (A)

$M_{SEI}$      Masse molaire de la SEI (kg.$mol^{-1}$)

$Q_s$      capacité résiduelle d'une électrode (Ah)

$r$      Coordonnée radiale dans le modèle 1 D

$R$      Constante des gaz parfaits (8.314 J $mol^{-1}$ $K^{-1}$)

$R_{ohm}$      Resistance ohmique ($\Omega$)

$R_{SEI}$      Resistance de la SEI ($\Omega$)

$R_s$      rayon des particules de matière active (m)

$S$      relatif au Solvant ou à la surface spécifique

$t$      temps (s)

$U$      potentiel thermodynamique (V)

$\beta$      Coefficient de transfert de charge

$\delta$      épaisseur des électrodes et/ou séparateur (m)

$\delta_{SEI}$      Epaisseur de la SEI (m)

$\varepsilon_e$      fraction volumique d'électrolyte

$\varepsilon_s$      fraction volumique de matière active

$\varepsilon_f$      fraction volumique de liant

$\rho_{SEI}$      masse volumique de la SEI (kg.$m^{-3}$)

$\kappa$      conductivité ionique de la SEI (S $m^{-1}$)

$\varphi$      flux thermique (W)

amb      ambiant (température)

Brugg      Bruggman coefficient

ct      relatif au transfert de charge

c      relatif à l'épaisseur critique de SEI

e      relatif à l'électrolyte

eff      relatif aux propriétés effectives

D      relatif au phénomène de diffusion

gen      relatif au flux thermique généré durant l'utilisation de la batterie

int  relatif à la réaction d'intercalation

n  électrode négative

p  électrode positive

ref  température de référence

SEI  relatif à la SEI

solvent  relatif au solvent

tra  relatif au flux thermique transféré à l'environnement

Ainsi, en appliquant ce modèle de vieillissement dynamique on détermine la perte de capacité (PC) ou la perte de puissance du système entre le début et la fin du profil d'utilisation, tout en considérant les évolutions, l'impact du profil entre le début et la fin du profil.

L'évolution dynamique de la capacité résiduelle de la batterie Qs au cours du vieillissement est calculée selon :

$$\frac{d}{dt}Q_s = i_s S_n$$

Ces pertes de capacité ou de puissance du système constituent un indicateur du vieillissement du système après avoir subi le profil d'utilisation.

L'étape suivante consiste à modifier le profil, de manière à minimiser cet indicateur, tout en respectant un certains nombres de contraintes.

3. Modification du profil de charge musqu'à obtenir un indicateur de vieillissement minimal (MODPR)

Le procédé selon l'invention se base sur une méthode d'optimisation sous contrainte.

Cette méthode permet de déterminer le profil d'utilisation qui minimise l'indicateur de vieillissement tout en respectant des contraintes. Ce profil optimal est noté $PR_{opt}(t)$. Dans le cas d'un profil de courant : $I_{opt}$ (t)

Ces contraintes sont choisies afin d'assurer la charge souhaitée. Elles peuvent être :

- imposer la valeur de l'intégrale du profil de charge, pour qu'elle soit égale à la capacité/énergie nécessaire pour que l'état de charge soit atteint comme spécifié ;

- une contrainte d'"upper bound" (ub) est imposée sur le courant/puissance de charge maximale ; Ce qui signifie que la puissance ne peut en aucun instant dépasser une valeur maximale imposée.

- imposer la capacité/énergie nécessaire pour la recharge souhaitée ;

- ...

Les algorithmes génétiques sont des algorithmes connus d'optimisation sous contrainte.

On peut également utiliser la fonction d'optimisation sous contrainte *fmincon* sous Matlab ®/Simulink®.

De façon générale, *fmincon* est utilisée pour la recherche des solutions aux problèmes suivants:

$$\min_x f(x) \text{ such that} \begin{cases} c(x) \le 0 \\ c_{eq}(x) = 0 \\ Ax \le b \\ A_{eq}x = b \\ lb \le x \le ub \end{cases}$$

Une telle recherche d'optimum se fait à travers le calcul, par différences finies à partir d'un point $x_0$ donné, de l'Hessien du Lagrangien L associé :

$$L(x, \lambda, \mu) = f(x) + \lambda c(x) + \mu c_{eq}(x)$$

Selon le procédé :

- la variable x représente le profil d'utilisation : opportunément discrétisé avec des paliers constants de durée fixée ;
- c(x)<0 représente une contrainte d'inégalité non linéaire ;
- $c_{eq}$(x)=0 représente une contrant d'égalité non linéaire ;
- Ax<b représente une contrainte linéaire d'inégalité ;
- $A_{eq}$ =b représente une contrainte linéaire d'égalité, utilisé ici pour imposer l'énergie souhaitée ;
- La variable Ib représente la limite inférieure aux valeurs de puissance ou courant;
- La variable ub représente la limite supérieure aux valeurs de puissance ou courant;
- La variable *f* à minimiser est l'indicateur de l'état de santé ou State-Of-Health (SOH) du système. Il peut s'agir de la perte de capacité de la batterie par exemple.

La variable *f* est calculée en fonction du profil de courant/puissance au moyen du modèle Simulink® de la cellule de la batterie (MSP).

La variable indépendante P/I (Puissance/Courant) se constitue de N paliers de courant/puissance $I_i/P_i$ chacun de la durée de $\Delta t$. Le courant maximal est fixé à $I_{max}$ alors que la puissance maximale $P_{max}$ peut-être fixée à la puissance du chargeur.

La contrainte $A_{eq}x=b$ est utilisée pour imposer la capacité/énergie nécessaire pour la recharge souhaitée, c'est à dire $\Delta t \Sigma I_i = \Delta Ah_{rech}$ ou $\Delta t \Sigma P_i = \Delta E_{rech}$, avec :

- $\Delta Ah_{rech}$ la quantité de charge que l'on souhaite stocker dans la cellule ;

- $\Delta E_{rech}$ la quantité d'énergie que l'on souhaite stocker dans la cellule.

**Utilisation du procédé**

Dans un premier exemple, le procédé selon l'invention est utilisé pour investiguer et définir des profils de charge à courant constant (CC). Ce type de profil est classiquement utilisé à l'échelle industrielle.

Concernant l'impact du courant sur la durée de vie des batteries, il est généralement admis que les forts courants de charge (C-Rate) dégradent fortement la durée de vie du système : plus le régime de charge est important, plus la durée de vie de la batterie est faible. Un modèle de vieillissement calibré sur une technologie LFP-graphite 2.3Ah est ici utilisé pour investiguer et quantifier l'impact du régime de charge sur la durée de vie de la batterie. Sous l'hypothèse d'une charge unitaire par jour, de 30% à 100% de SOC, différents niveaux de courant ont été testés en simulation comme illustré sur la figure 4. La figure 4 illustre les pertes de capacité (PC) après 1800 charges CC à différents C-Rates en fonction du type de refroidissement h (« cooling »).

La figure 4 présente un résultat qui va contre les spécifications généralement attendues pour la recharge de batteries pour application véhicule. La présence d'un optimum autour de 3C montre qu'il serait possible de charger la batterie en 20 min, tout en minimisant la perte de capacité du système. Une charge trop lente (C/8 : Charge "normale" en 8h) ou au contraire trop rapide (7C : Charge en 8.5 min) doubleraient le vieillissement de cette technologie de batteries Li-ion.

Dans un second exemple, le procédé selon l'invention est utilisé pour définir le profil de courant optimum de recharge qui permet de réduire le vieillissement du système au maximum.

Le profil initial (étape 1 du procédé) est une charge à courant constante qui permet de charger la batterie en 8h. On impose que l'intégrale du profil de charge (courant) sur les 8 heures de charge soit égale à la capacité nécessaire pour que l'état de charge atteigne la valeur finale de 95%, étant donné un SOC initial de 30%. Durant les deux dernières heures, la recharge n'est pas autorisée afin d'assurer une relaxation thermique. Chaque heure est "découpée" en intervalles de 10 min.

Le procédé est appliqué avec le modèle décrit dans le tableau 1.

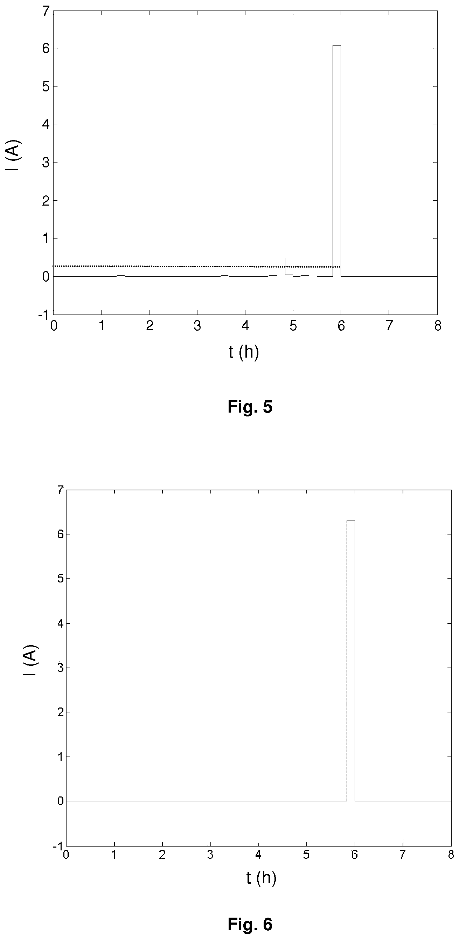

La figure 5 montre le résultat d'optimisation de profil de charge obtenu au moyen du procédé selon l'invention.

Il s'agit d'un profil de courant optimal (ligne pleine). Le profil initial étant représenté par une ligne pointillé.

Le premier résultat illustré sur la figure 5 montre qu'il est préférable de recharger la batterie "au plus tard". Ceci s'explique par le fait qu'on limite le temps passé à des états de charges élevés du système. Il est connu dans la littérature que des SOC élevés accélèrent le vieillissement du système batterie.

Un second résultat très intéressant montre que la charge s'effectue de façon pulsée. Ce résultat peut s'expliquer par le fait que le modèle intègre le phénomène de diffusion dans les électrodes et dans l'électrolyte. Il a été montré dans la littérature que l'imposition de signaux pulsés pouvait avoir des effets bénéfiques sur la durée de vie de batterie Li-ion.

Un troisième résultat porte sur la valeur du dernier pulse de charge. Ce dernier pulse a pour valeur 6.1 A. Cette valeur est très proche du régime de 3C pour lequel un optimum a été trouvé en simulation (figure 4) dans le premier exemple. Lors de ce dernier pulse, la majeure part de la recharge s'effectue.

## Avantages

Le procédé selon l'invention est adaptatif comme l'illustre les figures 5 et 6. En effet, en fonction de l'état de charge initial de la batterie, le profil optimal est différent.

La figure 6 illustre un résultat d'optimisation de profil de charge obtenu au moyen du procédé selon l'invention. Il s'agit d'un profil de courant optimal

Le profil de la figure 5 est obtenu en appliquant le profil de charge à une batterie dont le SOH initial est de 100%. Le SOH est l'indicateur de l'état de santé (State-Of-Health) du système.

Le profil de la figure 6 est obtenu en appliquant le profil de charge à une batterie dont le SOH initial est de 80 %.

Le procédé selon l'invention permet donc de prendre en compte les transitoires électriques et thermiques, ainsi que l'état initial du vieillissement, ce qui conduit à des résultats plus précis.

De plus, le procédé selon l'invention permet de faire ressortir le caractère pulsé de la charge.

## Revendications

1. Procédé d'utilisation d'un système de stockage d'énergie électrique, ledit système comportant une électrode positive, une électrode négative et un électrolyte, dans lequel :

   - on définit un profil optimal d'utilisation dudit système permettant de minimiser le vieillissement dudit système, ledit profil optimal d'utilisation étant défini en réalisant les étapes suivantes :

      i) on choisit un profil initial d'utilisation ;
      ii) on définit un modèle dynamique de vieillissement dudit système modélisant des pertes de capacité électrique et/ou de puissance dudit système, ledit modèle étant un modèle dynamique en ce qu'il modélise les pertes en fonction du temps et en ce qu'il prend en compte un état de vieillissement initial dudit système avant application dudit profil initial d'utilisation ;
      iii) on détermine un indicateur de vieillissement du système après application dudit profil initial d'utilisation audit système, au moyen dudit modèle dynamique de vieillissement ;
      iv) on modifie le profil d'utilisation initial et l'on réitère à l'étape iii) jusqu'à obtenir un indicateur de vieillissement minimal ;

   - et on applique ledit profil optimal audit système.

2. Procédé selon la revendication 1, dans lequel ledit modèle dynamique de vieillissement prend en compte un impact du profil d'utilisation sur ledit système tout au long du profil d'utilisation.

3. Procédé selon l'une des revendications précédentes, dans lequel ledit modèle dynamique de vieillissement décrit des pertes de capacité électrique et/ou de puissance dudit système en fonction de facteurs opérationnels de courant, de température, d'état de charge (SOC), et de balayage de plage d'état de charge (DOD).

4. Procédé selon l'une des revendications précédentes, dans lequel ledit modèle dynamique de vieillissement reproduit le comportement dynamique électrochimique et thermique dudit système, en modélisant les mécanismes de dégradation des électrodes menant à une perte de capacité et une perte de puissance.

5. Procédé selon la revendication 4, dans lequel ledit modèle dynamique de vieillissement comporte :

   - un modèle décrivant une évolution d'une couche de particule formée en surface d'une électrode;
   - un modèle décrivant que l'épaisseur de ladite couche croît par consommation d'espèces actives ;
   - un modèle décrivant que des molécules de l'électrolyte se réduisent à une interface entre une électrode et ladite couche après avoir traversées ladite couche par diffusion et convection.

**6.** Procédé selon l'une des revendications précédentes, dans lequel le profil d'utilisation est un profil de courant ou un profil de puissance.

**7.** Procédé selon l'une des revendications précédentes, dans lequel le profil d'utilisation est un profil de charge dudit système ou un profil de décharge dudit système, ou un profil correspondant à un ensemble de charges et de décharges.

**8.** Procédé selon l'une des revendications précédentes, dans lequel ledit système de stockage d'énergie électrique est une batterie Li-ion, ou Ni-MH, ou Pb-Acide ou une ultracapacité.

**9.** Procédé selon l'une des revendications précédentes, dans lequel l'indicateur de vieillissement est une perte de capacité électrique ou une perte de puissance.

**10.** Procédé selon l'une des revendications précédentes, dans lequel on modifie le profil d'utilisation jusqu'à obtenir un indicateur de vieillissement minimal au moyen d'un algorithme d'optimisation sous contrainte.

**Patentansprüche**

**1.** Verfahren zur Verwendung eines Systems zum Speichern von elektrischer Energie, wobei das System eine positive Elektrode, eine negative Elektrode und einen Elektrolyten aufweist, wobei:

- ein optimales Nutzungsprofil des Systems definiert wird, das ermöglicht das Altern des Systems zu minimieren, wobei das optimale Nutzungsprofil definiert wird, indem die folgenden Schritte durchgeführt werden:

i) es wird ein anfängliches Nutzungsprofil gewählt;
ii) es wird ein dynamisches Alterungsmodell des Systems definiert, das die Verluste der elektrischen Kapazität und/oder der Leistung des Systems modelliert, wobei das Modell dadurch ein dynamisches Modell ist, dass es die Verluste in Abhängigkeit von der Zeit modelliert und dass es einen anfänglichen Alterungszustand des Systems vor dem Anwenden des anfänglichen Nutzungsprofils berücksichtigt;
iii) es wird ein Alterungsindikator des Systems nach dem Anwenden des anfänglichen Nutzungsprofils auf das System mittels des dynamischen Alterungsmodells bestimmt;
iv) es wird das anfängliche Nutzungsprofil modifiziert und es wird in dem Schritt iii) wiederholt, bis ein minimaler Alterungsindikator erhalten wird;

- und es wird das optimale Profil auf das System angewendet.

**2.** Verfahren nach Anspruch 1, wobei das dynamische Alterungsmodell eine Auswirkung des Nutzungsprofils während des gesamten Nutzungsprofils auf das System berücksichtigt.

**3.** Verfahren nach einem der vorhergehenden Ansprüche, wobei das dynamische Alterungsmodell Verluste der elektrischen Kapazität und/oder der Leistung des Systems in Abhängigkeit von Betriebsfaktoren des Stroms, der Temperatur, des Ladezustands (SOC) und des Abtastens des Ladezustandsbereichs (DOD) beschreibt.

**4.** Verfahren nach einem der vorhergehenden Ansprüche, wobei das dynamische Alterungsmodell das elektrochemische und thermische dynamische Verhalten des Systems reproduziert, indem dieSchädigungsmechanismen der Elektroden, die zu einem Kapazitätsverlust und zu einem Leistungsverlust führen, modelliert werden.

**5.** Verfahren nach dem Anspruch 4, wobei das dynamische Alterungsmodell Folgendes aufweist:

- ein Modell, das eine Entwicklung einer Partikelschicht beschreibt, die auf der Oberfläche einer Elektrode gebildet wird;
- ein Modell, das beschreibt, dass die Dicke der Schicht durch Verbrauch von aktiven Spezies wächst;
- ein Modell, das beschreibt, dass sich die Moleküle des Elektrolyts an einer Schnittstelle zwischen einer Elektrode und der Schicht verringern, nachdem sie die Schicht durch Diffusion und Konvektion durchquert haben.

**6.** Verfahren nach einem der vorhergehenden Ansprüche, wobei das Nutzungsprofil ein Stromprofil oder ein Leistungsprofil ist.

**7.** Verfahren nach einem der vorhergehenden Ansprüche, wobei das Nutzungsprofil ein Ladeprofil des Systems oder ein Entladeprofil des Systems oder ein Profil ist, das einer Gruppe von Ladungen und Entladungen entspricht.

**8.** Verfahren nach einem der vorhergehenden Ansprüche, wobei das System zum Speichern von elektrischer Energie eine Lithium-Ionen-Batterie oder Ni-MH-Batterie oder Blei-Säure-Batterie oder eine Ultra-Kapazität ist.

**9.** Verfahren nach einem der vorhergehenden Ansprüche, wobei der Alterungsindikator ein Verlust der elektrischen Kapazität oder ein Leistungsverlust ist.

**10.** Verfahren nach einem der vorhergehenden Ansprüche, wobei das Nutzungsprofil geändert wird, bis ein minimaler Alterungsindikator mittels eines Optimierungsalgorithmus unter Belastung erhalten wird.

**Claims**

**1.** A method for using an electrical energy storage system, said system including a positive electrode, a negative electrode and an electrolyte, comprising:

- defining an optimal usage profile for said system allowing aging of said system to be minimized, said optimal usage profile being defined by carrying out the following stages:

i) selecting an initial usage profile,
ii) defining a dynamic aging model for said system modelling electrical capacity and/or power losses of said system, said model being a dynamic model in that it models the losses as a function of time and in that it takes account of an initial aging state of said system prior to applying said initial usage profile,
iii) determining an aging indicator for the system after applying said initial usage profile to said system, by means of said dynamic aging model,
iv) modifying the initial usage profile and repeating stage iii) until a minimal aging indicator is obtained,

- and applying said optimal profile to said system.

**2.** A method as claimed in claim 1, wherein said dynamic aging model takes account of an impact of the usage profile on said system throughout the usage profile.

**3.** A method as claimed in any one of the previous claims, wherein said dynamic aging model describes electrical capacity and/or power losses of said system as a function of operational factors of current, temperature, state of charge (SOC) and state of charge range scan (DOD).

**4.** A method as claimed in any one of the previous claims, wherein said dynamic aging model reproduces the electrochemical and thermal dynamic behaviour of said system by modelling the electrode degradation mechanisms leading to capacity loss and power loss.

**5.** A method as claimed in claim 4, wherein said dynamic aging model comprises:

- a model describing an evolution of a particle layer formed at the surface of an electrode,
- a model describing that the thickness of said layer increases through the consumption of active species,
- a model describing that electrolyte molecules get reduced at an interface between an electrode and said layer after passing through said layer by diffusion and convection.

**6.** A method as claimed in any one of the previous claims, wherein the usage profile is a current profile or a power profile.

**7.** A method as claimed in any one of the previous claims, wherein the usage profile is a charge profile of said system or a discharge profile of said system, or a profile corresponding to a set of charges and discharges.

**8.** A method as claimed in any one of the previous claims, wherein said electrical energy storage system is a Li-ion, a Ni-MH, a Pb-Acid or an ultracapacity battery.

**9.** A method as claimed in any one of the previous claims, wherein the aging indicator is an electrical capacity loss or a power loss.

10. A method as claimed in any one of the previous claims, wherein the usage profile is modified until a minimal aging indicator is obtained using a constrained optimization algorithm.

**Fig. 1A**

**Fig. 1B**

$$PR_{init} \rightarrow I_{init}\,(t)$$

$$INDV \rightarrow PC$$

MODPR

MIN ?

N

Y

$$PR_{opt} \rightarrow I_{opt}\,(t)$$

**Fig. 2**

MA       SEI       SOL

$c_{solv}^{b}$

$c_{solv}^{*}$

$R_{s,n}$          $\delta_{SEI}$

**Fig. 3**

**Fig. 4**

**Fig. 5**

**Fig. 6**

## RÉFÉRENCES CITÉES DANS LA DESCRIPTION

**Documents brevets cités dans la description**

- FR 2961351
- FR 2970820
- US 20060071634 A
- US 20050156577 A
- EP 2193587 A
- US 20090208817 A

**Littérature non-brevet citée dans la description**

- **A. HOKE ; A. BRISETTE ; D. MAKSIMOVIC ; A. PRATT ; K. SMITH.** *Vehicle Power Propulsion Conference,* 2011
- **B. LUNZ ; H. WALZ ; D. U. SAUER.** *Vehicle Power Propulsion Conference,* 2011